# EUROPEAN PATENT APPLICATION

(11) **EP 1 595 973 A1**
(43) Date of publication of application: **16.11.2005**
(21) Application number: 05010151.8
(22) Date of filing: 10.05.2005
(51) Int. Cl.: C23C 16/44

(54) **Low temperature CVD chamber cleaning using dilute NF3**

(30) Priority: 12.05.2004 US 844103
(71) Applicant: AIR PRODUCTS AND CHEMICALS, INC., Allentown, PA 18195-1501 (US)
(72) Inventor: Ridgeway, Robert Gordon, Quakertown, PA 18951 (US); Ji, Bing, Allentown, PA 18104 (US); Maroulis, Peter James, Alburtis, PA 18011 (US)
(74) Representative: Schwabe - Sandmair - Marx

(57) **Abstract**

This invention relates to an improvement in *in-situ* cleaning of deposition byproducts in low temperature Plasma Enhanced Chemical Vapor Deposition (PECVD) chambers and hardware therein where process thermal budgets require minimization of the susceptor temperature rise. In the basic *in situ* PECVD process, a cleaning gas is introduced to the chamber for a time and temperature sufficient to remove films of the deposition byproducts and then the cleaning gas containing deposition byproducts removed from said PECVD chamber. The improvement for minimizing the susceptor temperature rise in a low temperature PECVD chamber during cleaning comprises:
employing a cleaning gas consisting essentially of NF₃ for cleaning and diluted with a sufficient amount of helium to carry away the heat developed during cleaning of the Plasma Enhanced Low Temperature Chemical Vapor Deposition chamber. The susceptor is maintained at 150 °C or below.

## Description

### BACKGROUND OF THE INVENTION

In the electronics industry, various deposition techniques have been developed wherein selected materials are deposited on a target substrate to produce electronic components such as semiconductors. One type of deposition process is chemical vapor deposition (CVD), wherein gaseous reactants are introduced into a heated processing chamber resulting in films being deposited on the desired substrate. One subtype of CVD is referred to a plasma enhanced CVD (PECVD), wherein a plasma is established in the CVD processing chamber. Exposing the reactants to the plasma in the CVD chamber increases their reactivity, thus, less heat is required in the chamber to yield the desired deposition.

Generally, all methods of deposition result in the accumulation of films and particulate materials on surfaces other than the target substrate, that is, the deposition materials also collect on the walls, tool surfaces, susceptors, and on other equipment used in the deposition process. Any material, film and the like that builds up on the walls, tool surfaces, susceptors and other equipment is considered a contaminant and may lead to defects in the electronic product component.

It is well accepted that deposition chambers and equipment must be periodically cleaned to remove unwanted contaminating deposition materials. A generally preferred method of cleaning deposition tools involves the use of perfluorinated compounds (PFC's), e.g., C₂F₆, CF₄, C₃F₈, SF₆, and NF₃ as cleaning agents. A chemically active fluorine species, such as ions and radicals, are generated by the combination of a plasma and the PFC's and the ions and radicals react with the film on the chamber walls and other equipment. The gaseous residue then is swept from the CVD reactor.

The following references are illustrative of processes for the deposition of films in semiconductor manufacture and the cleaning of deposition chambers:

US 5,421,957 discloses a process for the low temperature cleaning of cold-wall CVD chambers. The process is carried out, *in situ,* under moisture free conditions. Cleaning of films of various materials such as epitaxial silicon, polysilicon, silicon nitride, silicon oxide, and refractory metals, titanium, tungsten and their silicides is effected using an etchant gas, e.g., nitrogen trifluoride, chlorine trifluoride, sulfur hexafluoride, and carbon tetrafluoride. NF₃ etching of chamber walls thermally at temperatures of 400-600°C is shown.

US 6,067,999 discloses a two step cleaning process to control and minimize the emission of environmentally deleterious materials which comprises the steps of establishing a process temperature; providing a 15-25% mixture of NF₃ in an inert gas, e.g., helium, argon, nitrous oxide and mixtures at a flow rate of more than 55 sccm (standard cubic centimeter per minute), establishing a pressure of 1.5 to 9.5 Torr in the PECVD processing temperature, establishing a plasma in the processing temperature, establishing a low pressure in the processing chamber and establishing a plasma in the low pressure chamber.

US 5,043,299 discloses a process for the selective deposition of tungsten on a masked semiconductor, cleaning the surface of the wafer and transferring to a clean vacuum deposition chamber. In the selective tungsten CVD process, the wafer, and base or susceptor is maintained at a temperature from 350 to 500°C when using H₂ as the reducing gas and from 200 to 400°C when using SiH₄ as the reducing gas. Halogen containing gases, e.g., BCl₃ are used for cleaning aluminum oxide surfaces on the wafer and NF₃ or SF₆ are used for cleaning silicon oxides. Also disclosed is a process for cleaning CVD chambers using an NF₃ plasma followed by an H₂ plasma.

GB 2,183,294 A discloses the use of NF₃ for the *in situ* cleaning of CVD deposition hardware, boats, tubes, and quartz ware as well as semiconductor wafers. NF₃ is introduced to a heated reactor in excess of 350°C for a time sufficient to remove silicon nitride, polycrystalline silicon, titanium silicide, tungsten silicide, refractory metals and silicides.

### SUMMARY OF THE INVENTION

This invention relates to an improvement in *in-situ* cleaning of deposition byproducts in low temperature Plasma Enhanced Chemical Vapor Deposition (PECVD) chambers and hardware therein where process thermal budgets require minimization of the susceptor temperature rise. In the basic *in situ* PECVD process, a cleaning gas is introduced to the chamber for a time and temperature sufficient to remove the deposition byproducts and then the cleaning gas containing deposition byproducts removed from said PECVD chamber. The improvement for minimizing the susceptor temperature rise in a low temperature PECVD chamber during cleaning comprises:
employing a cleaning gas consisting essentially of NF₃ for cleaning and diluted with a sufficient amount of helium to carry away the heat developed during cleaning of the Plasma Enhanced Low Temperature Chemical Vapor Deposition chamber. The susceptor is maintained at 150 °C or below.

Several advantages can be achieved through the process described here. These include:
an ability to reduce the cleaning time through optimization of reduced temperature chamber clean; an ability to reduce susceptor temperature rise compared to some PCF clean chemistries by > 50 %;
an ability to reduce the cooling down period post clean by a concomitant amount and improve the throughput of the PECVD reactor used to deposit films;
an ability to reduce the susceptor cool down period after the chamber has been cleaned; and, an ability to clean at lower plasma energies.

### BRIEF DESCRIPTION OF THE DRAWINGS

Fig. 1 is a graph, showing ion intensity for SiF₄-profile for DOE-run of example 1.
Fig. 2 is a graph showing integrated SiF₄ emissions during experimental cleaning.

### DETAILED DESCRIPTION OF THE INVENTION

The use of traditional cleaning chemistries for the *in situ* cleaning of deposition byproducts such as silicon based films, silicon oxide, silicon nitride, silicon oxynitride, fluorinated silicon glass, and silicon carbide from low temperature Plasma Enhanced Chemical Vapor Deposition (PECVD) chambers, including the hardware contained therein has resulted, in particular, in a significant relative susceptor temperature rise during the chamber clean. In low temperature PECVD processes this over temperature, as it is sometimes referred, can potentially have deleterious effects on the active matrix used in the fabrication of semiconductor devices. To avoid the deleterious effects, the susceptor is allowed to cool before the next wafer is processed. Over temperatures, therefore, result in process quality issues associated with inadequate cooling of the susceptor within the low temperature Plasma Enhanced Chemical Vapor Deposition chamber and associated delays due to cooling process itself. This in turn has an impact on process throughput and ultimately the cost of manufacturing.

One can achieve low susceptor rise in the cleaning process, i.e., consistently maintain temperatures below 150° C by the use of a cleaning gas consisting essentially of NF₃ in helium wherein NF₃ is mixed with He in a mixing ratio from 10 to 15%, typically 12-14% by volume. This ratio preferably then, is maintained at the low NF₃ level to ensure cleaning with efficient transport of heat generated in the clean process away from hardware surfaces within the chamber and particularly the wafer susceptor.

In the cleaning process, a flow rate of at least 100 - 500 sccm of the mixture of NF₃ in helium is used to avoid the generation of over temperatures. Lower flow rates may result in increased time required to adequately clean the chamber and hence increased temperature rise due to longer plasma exposure. Clean times of from 50 to 80 seconds per micron of film deposited are employed.

Plasma levels of 0.6 to 4.8 w/cm² are used at these conditions to remove at least 90 % of the deposited film within the allotted time of 80 to 140 seconds per micron of film deposited. O₂ and C₂F₆, and NF₃ in argon and nitrogen, for example, provide limited heat removal and often effect a significant surface temperature excursion in the susceptor. Susceptor temperatures often exceed 150°C. As mentioned, other clean chemistries based upon perfluorinated gases and dilutions with inert gases, e.g., argon, are inadequate for the *in situ* cleaning process. Using the described chemistries one can reduce this temperature rise by > 50 % as compared to other PCF chemistries. It is thought the conventional cleaning chemistries require higher levels to effect the same level of cleaning within the allotted time and they do not properly control the heat generation rate. In sum, there is an inability to remove the heat generated by such cleaning chemistries to consistently control the temperature of the susceptor.

The cleaning process described herein can be optimized for obtaining the best balance between chamber cleaning time and temperature rise minimization. The primary parameters affecting this balance include plasma power, pressure, NF₃ flow and He flow. Due to the lower bond energy of the N-F bond relative to the C-F bond, the use of NF₃ allows the clean to be conducted at lower plasma powers, relative to carbon-fluorine containing gases, yielding less energy dissipation in the chamber.

The following examples are provided to illustrate various embodiments of the invention and are not intended to restrict the scope thereof.

Experiments were designed to optimize gas consumption, and environmental impact, but also focusing on minimizing the temperature rise observed for the susceptor during the chamber clean. Evaluations were done using an experimental design approach. Design of Experiments (DOE) methodology was used to create empirical models correlating process parameters such as power, pressure and gas consumption to responses including clean time, susceptor temperature rise and etch by-product emissions.

Two distinct process chemistries were evaluated. These included the C₂F₆/O₂/NF₃ based chemistry, which is the standard clean chemistry used within the industry for HVM (high volume manufacturing) of current nonvolatile and volatile memory technology, and a chemistry based upon NF₃ diluted with He. In all cases, DOE results were compared to standard results.

To qualify as an acceptable cleaning chemistry, the following parameters were employed:
- a method of cleaning the chamber where the plasma energy was maintained in a range of 0.6 ― 4.8 watts/cm² with a preferable energy of 1.7 ― 2.7 watts/cm²;
- a method of cleaning the chamber with a clean time in the range of 80-140 sec per micron of dielectric film deposited;
- a method of cleaning the chamber whereby silicon is removed in the form of SiF₄ at a removal rate in the range of 0.20 ― 0.75 g/min per micron of dielectric film deposited; and,
- a method of cleaning the chamber on a substantially consistent basis where the susceptor temperature rise is kept in a range of 5 - 15° C for the duration of the clean, and the susceptor temperature rise being kept at 150 °C or below.

The following examples are used to illustrate various embodiments of the claims:

### Example I

In this example susceptor temperature rise, clean time and integrated SiF₄ emissions associated with the standard clean chemistry are compared to an optimized a dilute NF₃/helium cleaning chemistry. Experimental design methods were used to model responses for susceptor temperature rise, cleaning time to end point and integrated SiF₄ emissions as a function of plasma power, pressure and PFC flow rates. The models were created by imputing data into a commercially available statistical software. A central composite response surface model was created. Three center point replicates were run for each model. For each DOE run the chamber clean was timed at 45 sec. The film thickness deposited on the wafer was 3000 Angstroms for each run. Between each DOE run a 30 sec. chamber clean was run using the standard recipe to ensure that residual film was removed prior to the subsequent DOE run.

Data supporting models were acquired in the following manner. The susceptor temperature was monitored. The process clean time was determined from the signal intensity of SiF₄ (SiF³⁺) acquired by a mass spectrometer located on the process chamber. From these data a chamber clean end point could be determined. The end point was determined by extrapolating the flat portion of the SiF₄ profile shown in Graph 1 to the downward sloping portion.

Integrated SiF₄ emissions were used to compare the amount of silicon dioxide removed from the chamber during each experimental clean. SiF₄ emissions were integrated from the profile shown in Graph 2.

The optimization focused on minimizing susceptor temperature rise during the chamber clean. Table I contains the susceptor temperature rise, time required to reach a clean end-point (clean time) and integrated SiF₄ emissions for the standard process chemistry consisting of C₂F₆/O₂/NF₃ and using the Best Known Method (BKM) supplied by the Original Equipment Manufacturer (OEM). Specifically, the BKM recipe calls for 600 sccm C₂F₆/600 sccm O₂/75 sccm NF₃ at about 4 Torr chamber pressure and 3.1 W/cm² RF power. Table II contains the susceptor temperature rise, time required to reach a clean end-point (clean time) and integrated SiF₄ emissions for each run of the dilute NF₃ DOE.

The dilute NF₃ DOE parameters were NF₃flow rate, plasma power and chamber pressure. The responses included susceptor temperature rise after 35 sec of clean time, clean time end point and integrated SiF₄ emissions. Process ranges modeled include: NF₃ flow of 180 ― 520 sccm, chamber pressure of 0.7 ― 3.4 torr and plasma power of 1.38-2.93 watts/cm²

**Table I:**

| Responses For BKM Of Standard Clean Recipe Used For Cleaning SiO₂ From Chamber For 3000 A Deposition: | | | | |
|---|---|---|---|---|
| Run | Conditions | Susceptor Temp. @ 35 sec (°C) | Clean Time (sec) | Integrated SiF₄ Emissions (standard liters) |
| Std 1 | BKM | 157 | 30 | 0.038 |
| Std 2 | BKM | 156 | 30 | 0.038 |
| Std 3 | BKM | 156 | 30 | 0.037 |
| Std 4 | BKM | 156 | 32 | 0.041 |
| Std 5 | BKM | 156 | 32 | 0.043 |
| Std 6 | BKM | 156 | 30 | 0.041 |

**Table IIa:**

| Conditions for each run of the Dilute NF₃ DOE: The last column provides the conditions in coded terms where 0 represents center point, + and - represent high and low points, respectively, and a and A represent lower and upper star points, respectively. | | | | | |
|---|---|---|---|---|---|
| Run | NF₃ Flow (sccm) | He Flow (sccm) | Pressure (torr) | Power (Watts) | Coded Value |
| 1 | 350 | 2450 | 0.7¹ | 700 | 00a |
| 2 | 450 | 3150 | 2.8 | 550 | +-+ |
| 3 | 250 | 1750 | 2.8 | 850 | -++ |
| 4 | 182 | 1274 | 2.0 | 700 | A00 |
| 5 | 350 | 2450 | 2.0 | 950 | 0A0 |
| 6 | 350 | 2450 | 2.0 | 448 | 0a0 |
| 7 | 450 | 3150 | 1.2 | 550 | +-- |
| 8 | 450 | 3150 | 1.2 | 850 | ++- |
| 9 | 450 | 3150 | 2.8 | 850 | +++ |
| 10 | 350 | 2450 | 2.0 | 700 | 000 |
| 11 | 350 | 2450 | 2.0 | 700 | 000 |
| 12 | 250 | 1750 | 2.8 | 550 | --+ |
| 13 | 350 | 2450 | 2.0 | 700 | 000 |
| 14 | 250 | 1750 | 1.2 | 850 | -+- |
| 15 | 250 | 1750 | 1.2 | 550 | --- |
| 16 | 518 | 3626 | 2.0 | 700 | A00 |
| 17 | 350 | 2450 | 3.4 | 700 | 00A |

**Table IIb:**

| Responses For Dilute NF₃ DOE Runs Used For Cleaning SiO₂ From Chamber For 3000 A Deposition.. | | | | |
|---|---|---|---|---|
| Run | Conditions | Susceptor Temp. @ 35 sec (°C) | Clean Time (sec) | Integrated SiF₄ Emissions (standard liters) |
| 1 | 00a | 140 | 32 | 0.066 |
| 2 | +-+ | 138 | 36 | 0.039 |
| 3 | 0++ | 144 | 24 | 0.051 |
| 4 | a00 | 138 | 34 | 0.049 |
| 5 | 0A0 | 144 | 26 | 0.068 |
| 6 | 0a0 | 135 | 42 | 0.038 |
| 7 | +-- | 138 | 40 | 0.048 |
| 8 | ++- | 144 | 26 | 0.072 |
| 9 | +++ | 148 | 24 | 0.058 |
| 10 | 000 | 141 | 28 | 0.057 |
| 11 | 000 | 141 | 28 | 0.057 |
| 12 | --+ | 139 | 32 | 0.040 |
| 13 | 000 | 141 | 28 | 0.054 |
| 14 | -+- | 139 | 32 | 0.073 |
| 15 | --- | 136 | 42 | 0.062 |
| 16 | A00 | 142 | 28 | 0.060 |
| 17 | 00A | 143 | 28 | 0.044 |

The Example shows:
- A reduction of 13° ― 21 ° C for dilute NF₃/helium based cleaning chemistry relative to BKM of standard clean chemistry;
- Process end points of equivalent or even less times for dilute NF₃ chemistry relative to BKM of standard chemistry; and,
- Integrated SiF₄ emissions of 20 ― 70 % higher for dilute NF₃ chemistry relative to BKM of standard chemistry.

### Example 2: Comparison Of Model Simulated Conditions For Optimized Dilute NF₃ Based Chemistry Relative To Optimized Standard Chemistry:

In this example susceptor temperature rise, clean time and integrated SiF₄ emissions associated with the optimized standard clean chemistry are compared to an optimized dilute NF₃ cleaning chemistry. Experimental design methods were used to model responses for susceptor temperature rise, cleaning time to end point and integrated SiF₄ emissions as a function of plasma power, pressure and PFC flow rates. The models were created by imputing data into a commercially available statistical software. A central composite response surface model was created. Three center point replicates were run for each model. For each DOE run the chamber clean was timed at 45 sec. Between each DOE run a 30 sec. chamber clean was run using the standard recipe to ensure that residual film was removed prior to the subsequent DOE run.

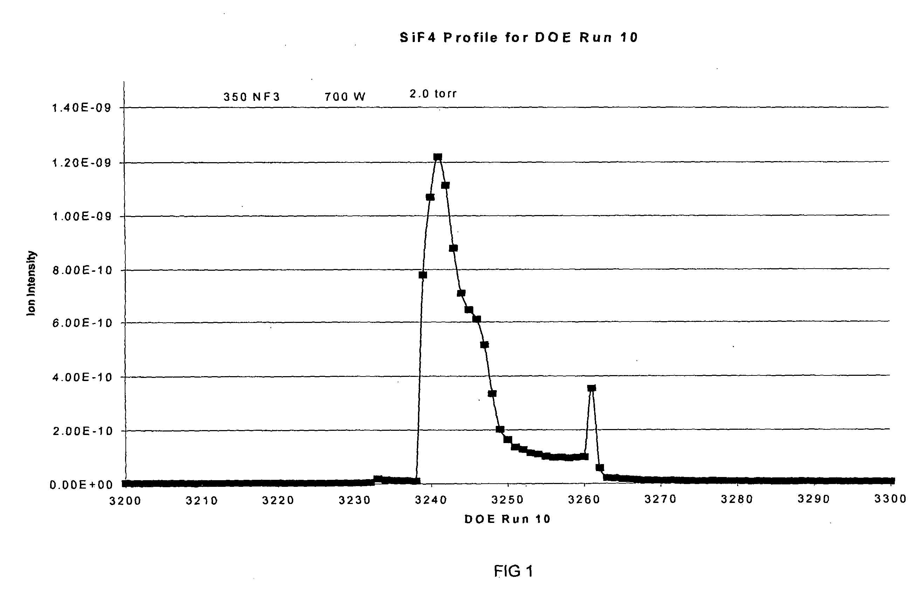

Data supporting models were acquired in the following manner. The susceptor temperature was monitored. The process clean time was determined from the signal intensity of SiF₄ (SiF₃⁺) acquired by a mass spectrometer located on the process chamber. From these data a chamber clean end point could be determined. The end point was determined by extrapolating the flat portion of the SiF₄ profile shown in Fig. 1 to the downward sloping portion as in Example 1.

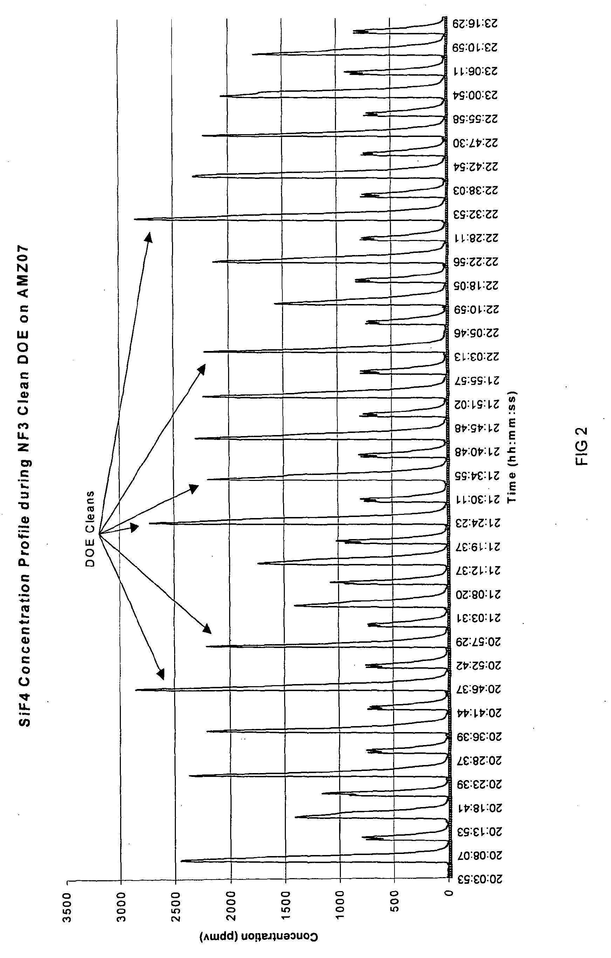

Integrated SiF₄ emissions were used to compare the amount of silicon dioxide removed from the chamber during each experimental clean. SiF₄ emissions were integrated from the profile shown in Fig. 2.

With the response surfaces generated for each chemistry, dilute NF₃ and standard C₂F₆/O₂/NF₃, simulations designed to compare chemistries for a specified clean time were generated. Table III contains simulated responses for susceptor temperature rise, clean time and integrated SiF₄ emissions for a 30 second clean using dilute NF₃ chemistry. Table IV contains simulated responses for susceptor temperature rise, clean time and integrated SiF₄ emissions for a 30 second clean using optimized standard chemistry. For each chemistry the predicted temperature rise is for a 35 second process, which includes the 30 second clean time plus a five second over etch.

**Table III:**

| Model Simulations Of Minimum Susceptor Temperature After 35 Sec. Of Plasma Exposure For Process Conditions Yielding Clean Time End Points Of 30 Sec. Or Less. In all of the runs in Table III, the He:NF₃ ratio is fixed at ca. 7:1 | | | | | |
|---|---|---|---|---|---|
| Simulation # | NF₃ Flow (sccm) | Power (watts/cm²) | Pressure (torr) | Predicted Temp. @ 35 sec. | Predicted Clean Time (sec) |
| 1 | 274 | 2.18 | 1.8 | 139.4 | 30 |
| 2 | 270 | 2.23 | 1.8 | 139.4 | 30 |
| 3 | 301 | 2.00 | 2.2 | 139.4 | 30 |
| 4 | 316 | 2.28 | 1.3 | 139.5 | 30 |
| 5 | 359 | 2.22 | 1.2 | 139.5 | 30 |

**Table IV:**

| Model Simulations Of Minimum Susceptor Temperature After 35 Sec. Of Plasma Exposure For Process Conditions Yielding Clean Time End Points Of 30 Sec. Or Less For C₂F₆/O₂/NF₃ Based Cleans. | | | | | |
|---|---|---|---|---|---|
| Simulation # | C₂F₆ Flow (sccm) | Power (watts/cm²) | Pressure (torr) | Predicted Temp. @ 35 sec. | Predicted Clean Time (sec) |
| 1 | 500 | 2.09 | 3.0 | 147.3 | 30 |
| 2 | 500 | 2.10 | 3.1 | 147.3 | 30 |
| 3 | 500 | 2.12 | 3.3 | 147.6 | 30 |
| 4 | 491 | 2.15 | 3.0 | 147.8 | 32 |
| 5 | 500 | 2.19 | 4.0 | 148.8 | 31 |

Comparison of Table III and Table IV indicate that a 30 % reduction in susceptor temperature rise is possible using dilute NF₃ based chemistry (10-15 volume % NF₃ in helium) relative to standard chemistry for a 30 second clean time. A 40 ― 50% reduction in the amount of PFC gas used is also possible with dilute NF₃ chemistry.

The use of dilute NF₃ chemistry will provide for sufficient reduction in susceptor temperature rise so as to allow for a significant increase in manufacturing capacity by reducing the amount of cooling required to process a subsequent wafer.

The benefits of the present invention can provide:

An optimized dilute NF₃ process that can significantly reduce susceptor temperature rise relative to the POR chamber clean based on standard chemistry and using a BKM supplied by the equipment manufacturers;

Dilute NF₃ can reduce temperature rise by 17°C compared to BKM using standard chemistry and supplied by the equipment manufacturers. This reduces cooling period in half yielding a 45 % decrease in total cleaning time;

Dilute NF₃ yielded the fastest clean times;

Dilute NF₃ yielded the lowest PFC emissions ― an 84 % reduction compared to BKM using standard chemistry and supplied by the equipment manufacturers; and,

Dilute NF₃ yielded the highest integrated SiF₄ emissions suggesting a wider area of cleaning. The effect of this on process performance is unknown.

These results can be used by semiconductor process engineers to select chamber clean conditions that will work best in manufacturing of devices requiring extremely low thermal budgets of less than 150° C. If throughput is the most critical parameter, dilute NF₃ would appear to be the best type of clean. Similarly if green house gas emissions were a concern, dilute NF₃ would also appear to provide the best advantage at reducing emissions.

In summary, the chamber clean is optimized to establish the best balance between the time required to adequately clean the chamber and minimization of the rise in susceptor temperature resulting from ion bombardment. This optimization is based on gas flow and power applied to create and sustain the in-situ plasma. Results of a comprehensive study comparing the use of this invention to the industry standard fluorocarbon (C₂F₆) based clean indicate a 50 % decrease in susceptor temperature rise for the optimized dilute NF₃ clean for processes running below 150°C. The clean time was also reduced for optimized dilute NF₃ by 15 %. Emissions of global warming gases were reduced by > 80 % for the dilute NF₃ based clean relative to the standard fluorocarbon based clean.

## Claims

1. In a process for the *in-situ* cleaning of films of silicon deposition byproducts in a low temperature Plasma Enhanced Chemical Vapor Deposition (PECVD) chamber and hardware where a cleaning gas is introduced to the chamber for a time and temperature sufficient to remove the silicon deposition byproducts and then the cleaning gas containing deposition byproducts removed from said PECVD chamber, the improvement where process thermal budgets require minimization of the susceptor temperature rise during cleaning which comprises:
employing a cleaning gas consisting essentially of a sufficient amount of NF₃ for cleaning and a sufficient amount of helium to carry away the heat developed during cleaning of the PECVD chamber.

2. The process of Claim 1 wherein the cleaning gas consists essentially of from 10 to 15 volume % NF₃ in helium.

3. The process of Claim 2 wherein the susceptor temperature is maintained at 150 °C or below.

4. The process of Claim 3 wherein the flow rate of cleaning gas employed in said cleaning step is from 100 to 500 sccm.

5. The process of Claim 4 wherein the power in said cleaning chamber is from 0.6 to 4.8 watts/cm².

6. The process of Claim 5 wherein the susceptor temperature rise during the clean is maintained from 5 to 15 °C.

7. The process of Claim 6 wherein the clean rate is from 0.2 to 0.75 grams/min per micron of film of silicon deposition byproduct.

8. The process of Claim 3 wherein the cleaning gas consists essentially of from 12- 14 volume % NF₃ by volume and the balance is helium.

9. The process of Claim 8 wherein the power level of said PECVD process is from 1.7 to 2.7 watts/cm².
